# EUROPEAN PATENT SPECIFICATION

(11) **EP 2 790 995 B1**
(45) Date of publication and mention of the grant of the patent: **26.10.2016**
(21) Application number: 12801496.6
(22) Date of filing: 27.11.2012
(51) Int. Cl.: B62D 1/06, G01D 5/24

(54) **PROXIMITY AND CONTACT SENSOR DEVICE IN MOTOR VEHICLE STEERING WHEELS.**
NÄHERUNGS- UND BERÜHRUNGSSENSORVORRICHTUNG IN FAHRZEUGLENKRÄDERN
DISPOSITIF DE CAPTEUR DE PROXIMITÉ ET DE CONTACT DANS DES VOLANTS DE DIRECTION DE VÉHICULE À MOTEUR

(30) Priority: 16.12.2011 IT VE20110080
(43) Date of publication of application: 22.10.2014
(73) Proprietor: I.R.C.A. S.p.A. Industria Resistenze Corazzate e Affini, 31020 San Vendemiano (IT)
(72) Inventor: RISPOLI, Omar, I-31020 San Vendemiano (IT); ZOPPAS, Federico, I-31020 San Vendemiano (IT)
(74) Representative: Piovesana, Paolo
(86) International application number: PCT/EP2012/073715
(87) International publication number: WO 2013/087408

(56) References cited:
- EP-A1- 1 814 226
- DE-A1-102007 019 957
- DE-C1- 10 048 956
- DE-U1- 20 309 603
- DE-U1- 20 309 877
- US-A- 5 722 686

## Description

The present invention relates to a proximity and contact sensor device in motor vehicle steering wheels.

Vehicle steering wheels are known provided with a proximity and contact sensor.

A first known type of steering wheel comprises a metal wire, wrapped about the annular portion of the steering wheel and connected to a capacitive sensor. The wire is covered with a sponge layer to eliminate the drawback of poor appearance of the projecting wire, especially if leather cladding is used, the surface of which is perfectly smooth.

On the other hand, if cavities were provided on the steering wheel to house the wire, this would involve an additional cost with lost time and labour involvement to carry out the work.

Another drawback is the fact that the wire cannot be applied to the spokes.

A further drawback is the fact that the wire cannot be screened to reduce disturbances.

DE 10 2007 019957 A1 relates to a device having a sensor system of flat conductive structures that form at least one folded capacitor and that are attached to the steering wheel rim 1 or operating element to detect secure operation of the device by the driver.

The object of the invention is to provide a proximity and contact sensor device for vehicle steering wheels which does not give rise to an unpleasant outer appearance deriving from wrinkles, reliefs and deformations on the cladding materials.

This object is attained according to the invention by a proximity and contact sensor device in motor vehicle steering wheels as described in claim 1.

The present invention is further clarified hereinafter in the form of a preferred embodiment provided by way of non-limiting example, with reference to the accompanying drawings, in which:

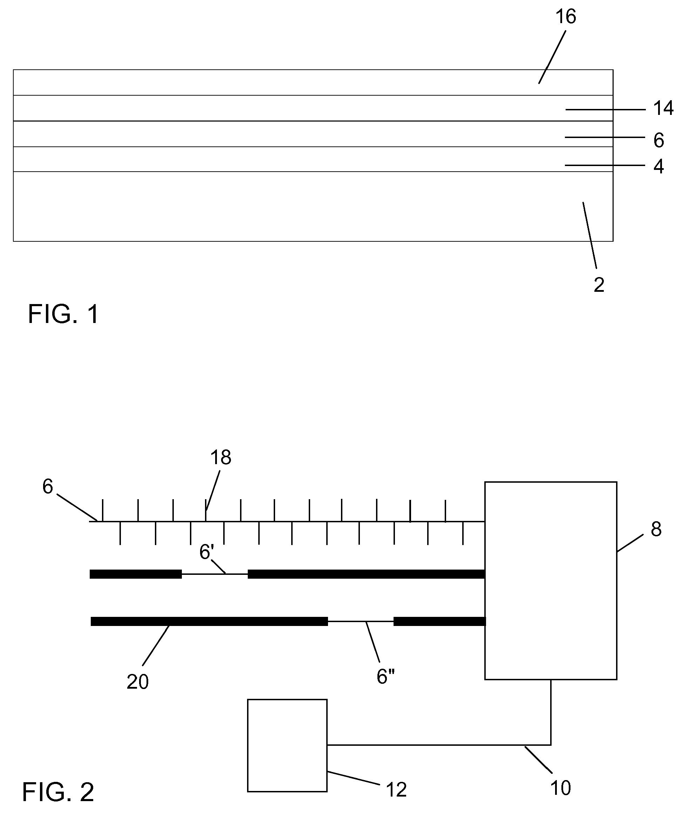

Figure 1 is a longitudinal part section through the device of the invention, and
Figure 2 is a schematic view thereof in the form of a block diagram.

As can be seen from the figures, the proximity and contact sensor device according to the invention comprises substantially a rectangular extendable band 2 of about 0.3 mm thickness, one surface of which is covered with an adhesive layer 4 on which a plurality of flat conductive tracks 6, 6', 6", preferably of aluminium, are applied, all connected to a capacitive multi-channel circuit 8, itself connected to the vehicle control unit 12 by a field bus 10.

The conductive tracks are covered with a second biadhesive layer 14 which is protected by a removable slider 16.

The tracks 6, 6', 6" perform the function of plates of a capacitor used as the sensitive element for proximity/contact sensing.

The conductive track 6 is formed such as to comprise a series of branches 18, whereas the tracks 6' and 6" are covered with an insulating material 20, with the exception of one portion.

In this manner capacitive sensing areas can be formed on the surface of the steering wheel rim for use for functions such as pushbuttons, for example for activating lights, direction indicators, etc.

In particular, the sensing system is developed on the basis of estimating the time constant required to obtain discharge of the capacitor formed by the plate present on the flexible circuit applied to the steering wheel and by that surrounding it, within an RC circuit.

From RC circuit theory it is known that if the initial state is considered to be that in which the capacitor of capacitance C is charged and presents across its ends an electrical potential difference V, then commencing its discharge through a load consisting of a resistor of ohmic value R, the voltage across the ends of the capacitor falls to about 37% of its initial value in a time τ where τ = RC. Consequently knowing the fixed resistance value R, the value of the capacitor can be estimated by measuring the time τ where C = τ/R.

On the basis of these considerations, the measurement system is able to perform the functions of charging the capacitor to a known voltage value and to discharge it through a suitably sized resistor and to measure the discharge time constant.

Consequently if the driver's hands are positioned in proximity to or in contact with the rim of the steering wheel, and hence just a few millimetres from the conductive track, a considerable increase in the equivalent conductive value thereof occurs. This is due to the fact that as the driver's body is a discrete electrical conductor, the hands act as a plate and form, together with the metal conductor of the heater, a non-ideal capacitor coupled to the vehicle metal parts.

The result is that if the driver's hands or fingers are rested on the track 6 or on the unscreened sections of the tracks 6', 6", they create a capacitance variation sensed by the circuit 8 which, by way of the bus 10, indicates this variation to the control unit which then causes activation of the connected function (activation of lights, direction indicators) or an emergency signal if the presence of the hands on the steering wheel is no longer sensed.

The device of the invention is formed in the following manner.

An aluminium sheet is bonded to a substantially rectangular extendable band 2 and is then subjected to silk screen printing treatment. That metal not protected by the ink is then removed to obtain continuous flat conductive tracks 6, 6', 6" onto which a further biadhesive layer 14 is applied and is covered by the liner 16.

From the aforegoing it is apparent that the contact sensor device for a steering wheel according to the invention presents numerous advantages, by virtue of the use of a conductive track obtained by the etched foil method typical of printed circuits, and in particular:
- it can be easily and comfortably mounted on the steering wheel,
- the cost of the aluminium track can be reckoned as only a quarter of the cost of wire conductors,
- the track can be branched and therefore have several active sensing zones,
- the presence of the extendable support means that no wrinkles are able to appear
- it is of small thickness because of the small thickness of the conductive track,
- it can be applied to the steering wheel spokes, which are then also used as a contact sensing zone,
- the rear part of the track can be screened by a PVD-deposited metal to prevent disturbances.

## Claims

1. A motor vehicle steering wheel with a proximity and contact sensor device, **characterised by** comprising an extendable band (2), the length of which is slightly less than the circumference of the steering wheel and of which one surface has fixed to it at least one conductive track (6, 6', 6") covered with a biadhesive layer (14), said conductive track consisting of a flat metal path obtained by treating a metal sheet applied to said extendable band, said conductive track being connected to a multi-channel capacitive sensor circuit (8) connected by a field bus (10) to the vehicle control unit (12).

2. A device as claimed in claim 1, **characterised in that** the metal is aluminium.

3. A device as claimed in any one of the preceding claims, **characterised in that** one (6) of the conductive tracks extends through the entire circumference of the steering wheel.

4. A device as claimed in any one of the preceding claims, **characterised in that** said tracks (6, 6") are partly covered with insulating material (20).

## Patentansprüche

1. Kraftfahrzeug-Lenkrad mit einer Näherungs- und Berührungssensorvorrichtung, **dadurch gekennzeichnet, dass** sie ein dehnbares Band (2) umfasst, dessen Länge geringfügig kürzer ist als der Umfang des Lenkrads und bei dem an einer Fläche davon mindestens eine Leiterbahn (6, 6', 6") befestigt ist, die mit einer doppelseitig klebenden Schicht (14) bedeckt ist, wobei die Leiterbahn aus einer flachen Metallbahn besteht, die durch Behandeln eines Blechs erhalten wird, das auf das dehnbare Band aufgebracht ist, wobei die Leiterbahn mit einer kapazitiven Mehrkanal-Sensorschaltung (8) verbunden ist, die über einen Feldbus (10) an die Fahrzeugsteuereinheit (12) angeschlossen ist.

2. Vorrichtung nach Anspruch 1, **dadurch gekennzeichnet, dass** das Metall Aluminium ist.

3. Vorrichtung nach einem der vorhergehenden Ansprüche, **dadurch gekennzeichnet, dass** eine (6) der Leiterbahnen über den gesamten Umfang des Lenkrads verläuft.

4. Vorrichtung nach einem der vorhergehenden Ansprüche, **dadurch gekennzeichnet, dass** die Bahnen (6, 6") teilweise mit Isolierstoff (20) bedeckt sind.

## Revendications

1. Volant de direction de véhicule à moteur doté d'un dispositif de capteur de proximité et de contact, **caractérisé en ce qu'**il comprend une bande extensible (2), dont la longueur est légèrement inférieure à la circonférence du volant de direction et dont une surface comporte fixée sur elle au moins une piste conductrice (6, 6', 6") recouverte d'une couche biadhésive (14), ladite piste conductrice consistant en un chemin métallique plat obtenu par un traitement d'une feuille métallique appliquée sur ladite bande extensible, ladite piste conductrice étant connectée à un circuit de capteur capacitif multivoie (8) connecté par un bus de terrain (10) à l'unité de commande (12) du véhicule.

2. Dispositif selon la revendication 1, **caractérisé en ce que** le métal est de l'aluminium.

3. Dispositif selon l'une quelconque des revendications précédentes, **caractérisé en ce que** l'une (6) des pistes conductrices s'étend sur toute la circonférence du volant de direction.

4. Dispositif selon l'une quelconque des revendications précédentes, **caractérisé en ce que** lesdites pistes (6, 6") sont partiellement recouvertes de matériau isolant (20).
